# EUROPEAN PATENT SPECIFICATION

(11) **EP 2 503 667 B1**
(45) Date of publication and mention of the grant of the patent: **19.03.2014**
(21) Application number: 11159552.6
(22) Date of filing: 24.03.2011
(51) Int. Cl.: H02J 13/00

(54) **Merging Unit and Method of Operating a Merging Unit**
Zusammenführungseinheit und Verfahren zum Bedienen einer Zusammenführungseinheit
Unité de fusion et procédé de fonctionnement d'une unité de fusion

(43) Date of publication of application: 26.09.2012
(73) Proprietor: Schneider Electric GmbH, 40880 Ratingen (DE); ALSTOM Technology Ltd, 5400 Baden (CH)
(72) Inventor: Rudolph, Thomas, 61191 Rosbach v.d.H. (DE)
(74) Representative: Manitz, Finsterwald & Partner GbR

(56) References cited:
- EP-A1- 1 134 867
- EP-A1- 1 830 450
- US-A1- 2004 059 469

## Description

### Field of the invention

The present invention relates to a merging unit, particularly for substation automation.

The present invention further relates to a method of operating a merging unit.

### Background

Merging units are e.g. used in substation automation systems for collecting and forwarding sensor data to further devices such as intelligent electronic devices (IEDs) provided for protection and/or control purposes on a higher level of said substation automation system.

US 2004/0059469 A1 discloses an electric power system with multiple electric circuits and phasor transducers, wherein the phasor transducers include inputs for receiving analog voltage and current sensor signals from the electric circuits which are sampled to generate digital value outputs. Phasor data representing the voltage and current are calculated from the digitally sampled data and a time stamp is applied to the phasor data. The phasor data is output to a further device using a communication network.

It is an object of the present invention to provide an improved merging unit and an improved method of operating a merging unit that provide an increased operational flexibility and enable a reduced complexity for higher level architectures of a substation automation system and provides a basis for electrical grid stability and wide area monitoring, protection and control schemes (WAMPAC).

### Summary

Regarding the abovementioned merging unit, this object is achieved by a merging unit according to claim 1. The merging unit comprises at least one input interface for receiving input data characterizing voltage and/or current measurements related to a component of a power system, wherein said merging unit further comprises a control unit that is configured to determine phasor measurement information depending on said input data.

The determination of phasor measurement information within the inventive merging unit advantageously enables to provide a simplified substation automation system architecture and provides the information required for enhanced electrical grid stability related to functions implemented on substation and/or network control center level.

According to a preferred embodiment, said merging unit is configured to transform said received input data into a predetermined output format, whereby transformed input data is obtained, and to output said transformed input data to a further device. Thus, input data collected by the merging unit can locally be processed within the merging unit and can be forwarded to external devices such as IEDs of the substation automation system in the desired data format. Alternatively or additionally, the phasor measurement information, which is determined by the control unit of the merging unit according to the embodiments, can also be transformed to a predetermined data format which e.g. facilitates evaluation of said phasor measurement information by other devices.

According to a further preferred embodiment, said merging unit is configured to output said phasor measurement information to a further device.

According to the invention, said merging unit is configured to assign timestamp information to said phasor measurement information and, preferably, to said input data and/or said transformed input data, which enables a particularly precise assessment of the data collected by the merging unit. Especially, further devices which are supplied with the respective data by the merging unit according to the embodiments, such as e.g. protection and/or control IEDs, can process the respective data, with a correct time reference, which is particularly advantageous if said data is delivered to the protection and/or control IEDs by various merging units that are geographically distributed.

According to the invention, said merging unit is configured to implement logical nodes according to the International Electrotechnical Commission, IEC, 61850-7 standard, wherein said logical nodes comprise TCTR and TVTR and at least one of: MMXU, MMXU including PMU (phasor measurement) data, GGIO. Thus, the merging unit according to the embodiments can advantageously make use of underlying data model as specified by the IEC 61850 standard.

According to a further preferred embodiment, said merging unit is configured to map information to and/or from said at least one logical node to at least one of the following communication protocols: IEC 61850-8-1 (Mapping to MMS) and IEC 61850-8-1 Generic Object Oriented Substation Event (GOOSE). According to the invention, said merging unit is configured to map information to and/or from the logical nodes to the communication protocols: IEC 61850-9-2 Sampled Measured Values (SMV) and IEC 61850-90-5 (Synchrophasor), whereby a particularly efficient communications process between the logical node(s) as implemented in the merging unit according to the embodiments and external devices such as e.g. protection and/or control IEDs is attained.

According to a further preferred embodiment, said merging unit is configured to map communications according to IEC 61850-8-1 to a, preferably dedicated, first physical communications port, and to map communications according to IEC 61850-9-2 to a, preferably dedicated, second physical communications port. Alternatively, the first physical communications port, which is proposed to support IEC 61850-8-1 communications, may also be employed for IEC 61850-9-2 communications. Further alternatively or additionally, communications according to the IEC 61850-90-5 or IEEE C37.118 standards may also be mapped to either one of said physical communications ports or further ports provided for communications.

A further solution to the object of the present invention is given by a method of operating a merging unit according to claim 8. Further advantageous embodiments are subject of the dependent claims.

### Brief description of the Figures

Further aspects, features and embodiments of the present invention are given in the following detailed description with reference to the drawings, in which:
- Fig. 1: depicts a schematic block diagram of an embodiment of the inventive merging unit,
- Fig. 2: depicts a detailed functional block diagram of an embodiment of the inventive merging unit, and
- Fig. 3: depicts a schematic block diagram of a third embodiment of the inventive merging unit.

### Detailed Description

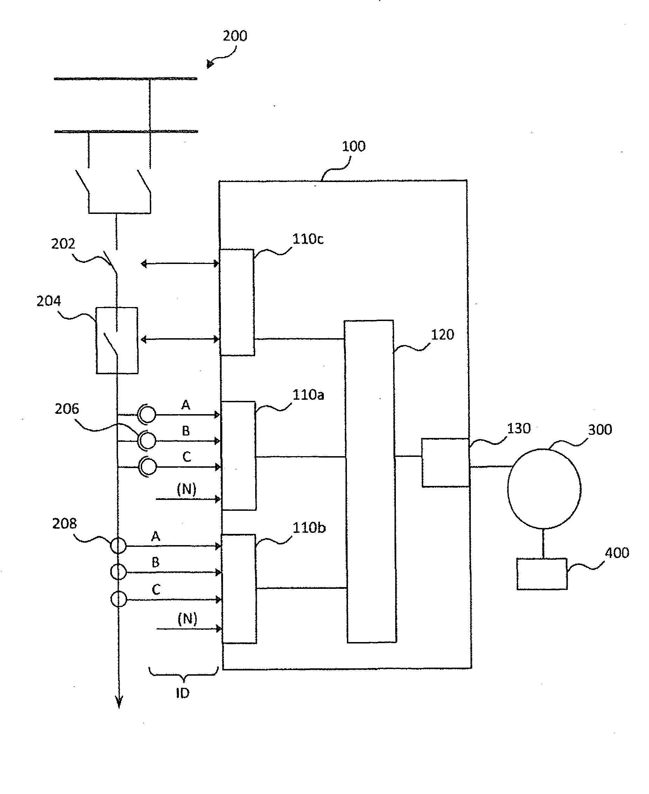

Fig. 1 depicts a schematic block diagram of a first embodiment of an inventive merging unit 100, which is assigned to a power system 200 for processing input data ID characterizing voltage and/or current measurements related to components of said power system 200.

Said power system 200 exemplarily comprises switchgear like disconnectors 202 and circuit breakers 204. Further, the power system 200 comprises one or more voltage transformers 206 and one or more current transformers 208 for transforming the voltages and/or currents of the power system 200 in a per se known manner, i.e. to reduced value ranges, to facilitate measurement and analysis of these parameters.

For example, the voltage transformers 206 may comprise conventional voltage transformers and/or non-conventional voltage transformers. Likewise, the current transformers 208 may comprise conventional current transformers and/or non-conventional current transformers such as e.g. noncontact current transformers (NCCT) of the Rogowski coil or fibre-optic type.

For receiving output signals of the voltage transformers 206 and the current transformers 208, which are further referred to as "input data" ID to the merging unit 100, the merging unit 100 comprises respective input interfaces. According to the present embodiment, the merging unit 100 comprises a first input interface 110a, which is configured to receive the output signals of the voltage transformers 206 as input data ID. The merging unit 100 also comprises a second input interface 110b, which is configured to receive the output signals of the current transformers 208 as input data ID.

Depending on the specific configuration of the voltage transformers 206 and the current transformers 208, the first input interfaces 110a, 110b comprise respectively configured input ports. For example, if the voltage transformers 206 are of the conventional type delivering an output voltage within e.g. a 0 V to 100 V range depending on a primary voltage of a component 204 of the power system 200 to which the voltage transformers 206 are connected, the first input interface 110a is capable of processing said respective input data within the specified voltage range. The same applies to the specific configuration of the second input interface 110b which is connected to the current transformers. I.e., for operating conventional current transformers, the second input interface 110b may e.g. be configured to receive a current signal within the 0 A to 5 A range.

Optionally, the merging unit 100 may also comprise at least one further input interface 110c, which is configured to receive input data in binary form such as e.g. from position indicators or other components of the power system 200 providing binary output data.

For processing the received input data ID, the merging unit 100 comprises a control unit 120, which may e.g. comprise a microprocessor and/or a digital signal processor (DSP) or any other type of calculating means that are capable of performing the required steps of processing.

After processing the input data ID, the merging unit 100 may forward processed input data to an external device. According to the embodiment of Fig. 1, the merging unit 100 comprises a data interface 130 which e.g. serves to establish a data connection with a network 300 and/or further devices 400, e.g. via said network 300.

For instance, the data interface 130 could comprise an Ethernet-type interface, which may provide data connections between the merging unit 100 and other Ethernet based devices as protection relays, bay computers, substation level devices like Gateways, substation computer or Human-Machine Interfaces (HMI) identified as substation Automation System (SAS), which may e.g. use IEC 61850-9-2 and IEC 61850-8-1 protocol as a option.

Generally, according to a preferred embodiment, the merging unit 100 is configured to perform measurements, preferably real-time measurements, of the input data ID as provided by the instrument transformers 206, 208, and to forward said measurements to further external components 400. As will be explained in detail below, the measurements related to the input data ID may inter alia comprise a transformation of those portions of input data received in the analog domain to the digital domain.

Presently, substation automation systems, which are used to control power systems 200 as exemplarily depicted by Fig. 1, are based on a functional distribution which is mainly structured into 3 levels: process Level, bay level and substation level. In this context, the merging unit 100 may typically represent a device of the substation level, and the device 400 may represent an intelligent electronic device (IED) in the sense of the IEC 61850 standard which is provided at the bay level, e.g. a protection or control IED.

According to the present invention, apart from performing said measurements, preferably real-time measurements, of the input data ID as provided by the instrument transformers 206, 208, and to forward said measurements to further external components such as bay level IEDs 400, the merging unit 100, or its control unit 120, respectively, is further configured to determine phasor measurement information depending on said input data ID or the associated measurements obtained via the input interfaces 110a, 110b. According to an embodiment, said phasor measurement information may e.g. be transmitted via the data interface 130 to further components, e.g. by employing communications according to the IEC 61850-90-5 (Synchrophasor) or IEEE C37.118 standards. Such further components may e.g. represent phasor data concentrators (PDCs).

Thus, in addition to forwarding voltage and/or current measurements to external devices 400, the inventive merging unit 100 advantageously enables to locally determine phasor measurements associated with the input data ID that reflects voltages and/or currents of the power system 200 the merging unit 100 is associated with. The phasor measurement information so obtained may also be forwarded to further devices 400. According to a preferred embodiment, the phasor measurements comprise a vectorial three-phase representation of voltages and currents at a fundamental network frequency of the power system 200 associated to the inventive merging unit 100.

By integrating the above explained functionality directed to determining phasor measurements, substation automation systems may be provided which comprise less IEDs, particularly on the bay level. Apart from saving costs by reducing the number of elements of the substation automation systems, higher accuracy regarding the phasor measurement information may also be attained since the phasor measurement information is determined at the same stage, i.e. the merging unit 100, where the basic input data ID for deriving said phasor measurement information is obtained.

Moreover, less documentation is required for substation automation systems that are equipped with the inventive merging units 100 since a higher degree of functional integration is provided.

Still further, the forwarding of phasor measurement information obtained according to the present invention may seamlessly be integrated with existing data exchange techniques such as e.g. according to the IEC 61850-90-5 or IEEE C37.118 standards.

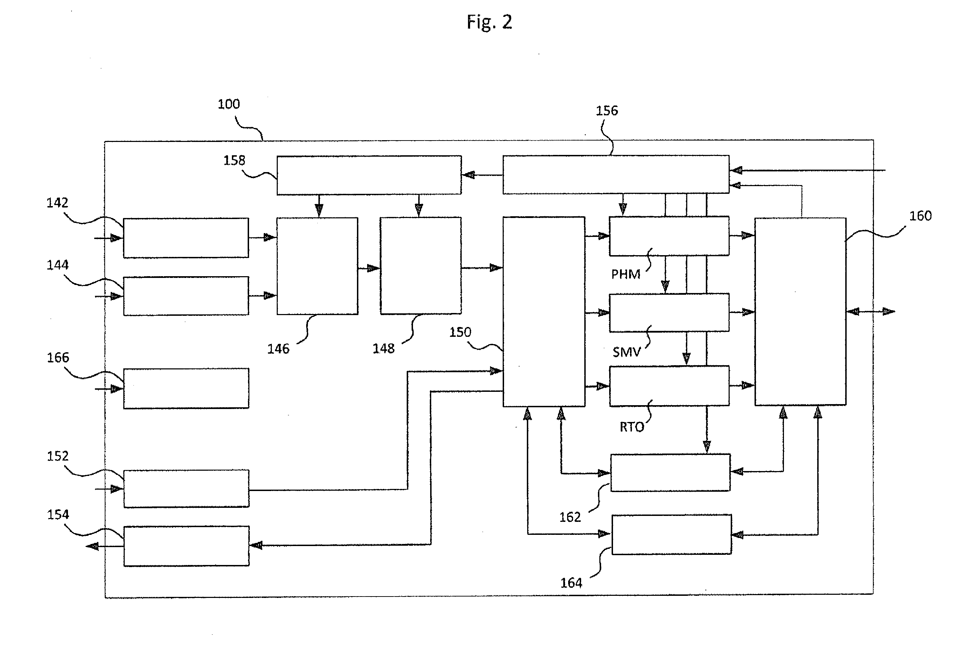

Fig. 2 depicts a detailed functional block diagram of an embodiment of the inventive merging unit 100.

As depicted by Fig. 2, the merging unit 100 comprises input conditioning means 142 for conditioning the output signals of the voltage transformers 206 (Fig. 1) as received at the first input interface 110a of the merging unit 100. Likewise, the merging unit 100 comprises input conditioning means 144 for conditioning the output signals of the current transformers 206 (Fig. 1) as received at the second input interface 110b of the merging unit 100.

Depending on a specific measurement scheme employed by the merging unit 100, the input conditioning means 142, 144 may be configured to provide standardized analog signals to a subsequent signal processing stage 146 that is configured to apply steps of filtering and sample and hold to the supplied signals. Optionally, internal signal paths or components of the processing stage 146 may be multiplexed in a per se known manner.

The processing stage 146 forwards respective output data to the analog to digital (A/D) converter means 148 which transform the analog output signals provided by the processing stage 146 to the digital domain. Thus, digital data representing the input data ID (Fig. 1), which relates to voltage and/or current values associated with the power system 200 may be forwarded to the digital signal processing means 150.

The merging unit 100 also comprises input conditioning means 152 for binary input data ID, such as received via the further input interface 110c (Fig. 1), which are configured to forward respectively conditioned binary input data to the digital signal processing means 150.

Optionally, output relay interface means 154 may also be provided at the merging unit 100 in order to enable external devices to be controlled like auxiliary relays, circuit breakers, disconnectors or any other equipment.

In order to enable time synchronization of the input data ID or the respective measurement values (e.g., digital samples as obtained by the ADC 148), time synchronization means 156 are provided. Said time synchronization means may provide an integrated clock and/or corresponding counter modules (not shown). Moreover, the time synchronization means 156 advantageously comprise an interface to an external synchronisation network, which operates according to the Inter Range Instrumentation Group, IRIG, -B and/or the 1PPS standards, and/or to Institute of Electrical and Electronics Engineers, IEEE, 1588.

A sample and conversion control 158 is supplied with respective timing information from the time synchronization means 156, whereby the steps of filtering, multiplexing, sample and hold and ADC within the components 146, 148 may performed with a precise time reference.

According to the present invention, the digital signal processing means 150 are configured to determine phasor measurement information PHM depending on said input data ID (Fig. 1) obtained from the respective input interfaces 110a, 110b. The phasor measurement information PHM, too, is associated with timing information supplied by the time synchronization means 156. Thus, precise time stamps can be assigned to the phasor measurement information PHM to facilitate a precise subsequent processing thereof in the context of the power system 200.

Additionally, the digital signal processing means 150 are configured to determine sample measured values SMV depending on said input data ID (Fig. 1) obtained from the respective input interfaces 110a, 110b. The sample measured values SMV may advantageously also be associated with timing information supplied by the time synchronization means 156.

Optionally, the digital signal processing means 150 may also be configured to determine further real-time operating measurements RTO, preferably also at least partially depending on said input data ID (Fig. 1) obtained from the respective input interfaces 110a, 110b. The further real-time operating measurements RTO may advantageously also be associated with timing information supplied by the time synchronization means 156.

As already mentioned before, the sampling of input data ID (Fig. 1) is controlled by the sample and conversion control 158 which is controlling as well the A/D converter 148. Since the sampled measured values SMV - as well as phasor measurement information PHM - requires a precise time synchronisation, the time synchronisation means 156 provide respective synch signals for the sample and conversion control 158 as well as for the time stamps of PHM, SMV, RTO, and optionally also for real-time digital information 162.

The digital signal processing means 150 preferably convert all signals into the related format and manage the binary I/O of the merging unit 100, cf. the blocks 152, 154 as well.

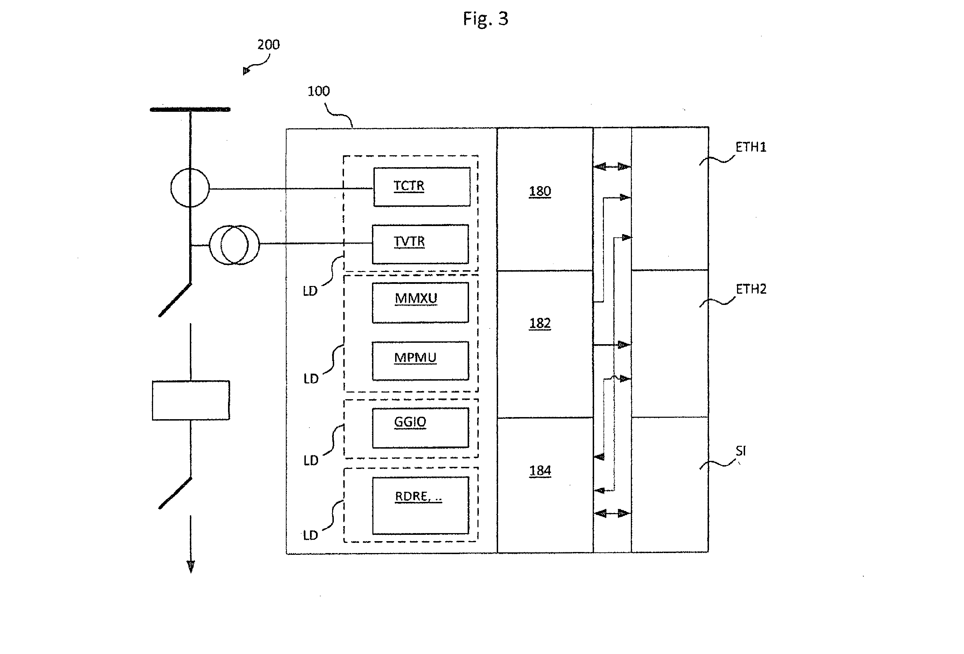

For exchange with further devices 400 (Fig. 1), all data to be exchanged are mapped by communications mapping means 160 to a predetermined related communication protocol, a variant of which will be explained below with reference to Fig. 3.

Furthermore, a configuration, setting and test block 164 may be provided which is using well-known protocols such as e.g. FTP (file transfer protocol) and HTTP (hyper text transfer protocol) for remote and local access to the merging unit 100. The implementation of the power supply 166 is depending on the application.

According to a preferred embodiment, one or more of the functional blocks of the merging unit 100 explained above with reference to Fig. 2 may advantageously be integrated to the control unit 120 (Fig. 1).

Fig. 3 depicts an internal structure of an inventive merging unit 100 according to an embodiment from the communication point of view based on IEC 61850. Following the IEC 61850 hierarchical concept of communication modelling, the physical device (PD) in the context of IEC 61850 is equivalent to the merging unit 100. The PD 100 contains one or more logical devices LD, cf. the dashed rectangles, which are used to group Logical Nodes LN (e.g. TCTR, TVTR, ..) which belong together like LNs TCTR, TVTR for transformers, and the like. Basically, according to a preferred embodiment, the merging unit 100 may provide the following LNs: TCTR, TVTR, MMXU, MMXU including PMU (phasor measurement) data, GGIO.

Further optional LNs are application depending: XCBR, XSWI, RDRE, CSWI, RSYN,... and may also be implemented by the inventive merging unit 100. Their use, however, is subject to setting of additional application functional blocks (AFBs).

According to a particularly preferred embodiment, the information originating from and/or to be supplied to the LNs are mapped to one of the following protocols according to the type of information: Status information, commands, settings and derived measurements are mapped to MMS reports based on IEC 61850-8-1, cf. the protocol block 180. In addition, derived measurements and binary information could e.g. be mapped to IEC 61850-8-1 GOOSE (Generic Object Oriented Substation Event) depending on the application, also cf. the protocol block 180. Sampled measured values (SMV) are mapped to IEC 61850-9-2 SMV by means of the further protocol block 182. Phasor measurement data may either also be mapped to one of the aforedescribed protocols by means of the protocol blocks 180, 182. However, according to a preferred embodiment, the phasor measurement data may be mapped to IEEE C37.118 and/or IEC 61850-90-5, cf. the respective protocol block 184.

The specific mapping of the communications supported by the protocol blocks 180, 182, 184 to physical interfaces is subject of setting. According to an embodiment, the IEC 61850-8-1 protocol block 180 is mapped to a dedicated Ethernet port ETH1. This port ETH1 may also be shared together with the IEC 61850-9-2 protocol block 182 and/or IEEE C37.118 and/or IEC 61850-90-5. Further, the IEC 61850-9-2 protocol block 182 may be mapped to a dedicated further Ethernet port ETH2 either separately or commonly together with IEEE C37.118 and/or IEC 61850-90-5.

Communications according to IEEE C37.118 and/or IEC 61850-90-5 may also be mapped to a serial communication link SI independently.

The physical implementation of the interfaces ETH1 and ETH2 and the related network topology is not subject of the present invention. The implementation could e.g. be wired (CAT5 or the like) or fibre optic, single or redundant port, in accordance with IEC 61850-90-4 or could comprise further communications channels capable of supporting the disclosed protocols. The same applies to the data rate of the interfaces ETH1, ETH2.

According to a preferred embodiment, one or more of the communications- and protocol-related blocks of the merging unit 100 explained above with reference to Fig. 3 may advantageously be implemented by the control unit 120 (Fig. 1) or its digital signal processing means.

The merging unit 100 according to the embodiments is going far beyond the conventional systems and implementations of phasor measurement assessment in dedicated IEDs or as a function in protection relays. Due to the emerging use of merging units 100, the invention is advantageously incorporating PHM data generation and/or analysis into the merging unit 100 and communicating conventional SMV as well as phasor measurement data PHM via the same or different communications ports ETH1, ETH2, SI to the upper level of a substation automation system comprising said merging unit 100. This advantageously ensures that the measurement of input data ID and the determination of phasor measurement information PHM can be done with the highest possible accuracy and less additional HW such as conventional dedicated IEDs for assessing power quality. The merging unit 100 according to the embodiments can advantageously use existing communications infrastructure and is open for future standardisation on communication protocol level.

According to a further preferred embodiment, the merging unit 100 according to the embodiments may be remote configured, e.g. via a HTTP interface or the like provided by the control unit 120 (Fig. 1) or a dedicated integrated web server module.

## Claims

1. Merging unit (100), particularly for substation automation, comprising at least one input interface (110a, 110b) for receiving input data (ID) characterizing at least one voltage and/or current related to a component of a power system (200), wherein said merging unit (100) comprises timing synchronization means (156) which comprise an interface to an external synchronization network operating according to one of the Inter Range Instrumentation Group, IRIG, -B standard, the 1PPS standard and the Institute of Electrical and Electronics Engineers, IEEE, 1588 standard, wherein the merging unit (100) is configured to implement logical nodes according to the International Electrotechnical Commission, IEC, 61850-7 standard, wherein the logical nodes comprise at least one of TCTR and TVTR, wherein the merging unit (100) is configured to determine sampled measured values, SMV, depending on said input data (ID) and to map information from at least one of the logical nodes to the IEC 61850-9-2 sampled measured values, SMV, communication protocol, and
wherein:
- said merging unit (100) comprises a control unit (120) that is configured to determine phasor measurement information (PHM) depending on said input data (ID),
- the merging unit (100) is configured to associate the phasor measurement information (PHM) with timing information supplied by the timing synchronization means (156),
- the logical nodes comprise at least one of MMXU, MMXU including PMU phasor measurement data and GGIO, and
- the merging unit (100) is configured to map information to and/or from at least one of the logical nodes to the IEC 61850-90-5 Synchrophasor communication protocol.

2. Merging unit (100) according to claim 1, wherein said merging unit (100) is configured to transform said received input data (ID) into a predetermined output format, whereby transformed input data is obtained, and to output said transformed input data to a further device (400).

3. Merging unit (100) according to one of the preceding claims, wherein said merging unit (100) is configured to output said phasor measurement information (PHM) to a further device (400).

4. Merging unit (100) according to one of the preceding claims, wherein said merging unit (100) is configured to assign timestamp information to said phasor measurement information (PHM) and/or said input data (ID) and/or said transformed input data.

5. Merging unit (100) according to claim 4, wherein said merging unit (100) is configured to map information to and/or from said logical nodes to at least one of the following communication protocols: IEC 61850-8-1, Mapping to MMS; IEC 61850-8-1 Generic Object Oriented Substation Event, GOOSE.

6. Merging unit (100) according to one of the preceding claims, wherein said merging unit (100) is configured to map communications according to IEC 61850-8-1 to a, preferably dedicated, first physical communications port (ETH1), and to map communications according to IEC 61850-9-2 to a, preferably dedicated, second physical communications port (ETH2).

7. Method of operating a merging unit (100), particularly for substation automation, wherein said merging unit (100) comprises at least one input interface (110a, 110b) for receiving input data (ID) characterizing at least one voltage and/or current related to a component of a power system (200), wherein said merging unit (100) comprises timing synchronization means (156) which comprise an interface to an external synchronization network operating according to one of the Inter Range Instrumentation Group, IRIG, -B standard, the 1PPS standard and the Institute of Electrical and Electronics Engineers, IEEE, 1588 standard, wherein the merging unit (100) implements logical nodes according to the International Electrotechnical Commission, IEC, 61850-7 standard, wherein the logical nodes comprise at least one of TCTR and TVTR, wherein the merging unit (100) determines sampled measured values, SMV, depending on the input data (ID), wherein the merging unit (100) maps information to and/or from at least one of the logical nodes to the IEC 61850-9-2 sampled measured values, SMV, communication protocol, and wherein:
- said merging unit (100) determines, using a control unit (120), phasor measurement information (PHM) depending on said input data (ID) the merging unit (100) associates the phasor measurement information (PHM) with timing information supplied by the timing synchronization means (156),
- the logical nodes comprise at least one of MMXU, MMXU including PMU phasor measurement data and GGIO, and
- the merging unit (100) maps information to and/or from at least one of the logical nodes to the IEC 61850-90-5 Synchrophasor communication protocol.

8. Method according to claim 7, wherein said merging unit (100) transforms said received input data (ID) into a predetermined output format, whereby transformed input data is obtained, and outputs said transformed input data to a further device (400).

9. Method according to one of the claims 7 to 8, wherein said merging unit (100) outputs said phasor measurement information (PHM) to a further device (400).

10. Method according to one of the claims 7 to 9, wherein said merging unit (100) assigns timestamp information to said phasor measurement information (PHM) and/or said input data (ID) and/or said transformed input data.

11. Method according to one of the claims 7 to 10, wherein said merging unit (100) maps information to and/or from said logical nodes to at least one of the following communication protocols: IEC 61850-8-1, Mapping to MMS; IEC 61850-8-1 Generic Object Oriented Substation Event, GOOSE; IEEE C37.118.

12. Method according to one of the claims 7 to 11, wherein said merging unit (100) maps communications according to IEC 61850-8-1 to a, preferably dedicated, first physical communications port (ETH1), and maps communications according to IEC 61850-9-2 to a, preferably dedicated, second physical communications port (ETH2).

## Patentansprüche

1. Zusammenführungseinheit (100), speziell zur Automatisierung von Unterstationen, die mindestens eine Eingabeschnittstelle (110a, 110b) zum Empfangen von Eingabedaten (ID) umfasst, welche mindestens eine Spannung und/oder einen Strom mit Bezug auf eine Komponente eines Leistungssystems (200) beschreiben, wobei die Zusammenführungseinheit (100) Zeitsynchronisierungsmittel (156) umfasst, welche eine Schnittstelle zu einem externen Synchronisationsnetzwerk umfassen, das gemäß dem Standard IRIG-B der Inter Range Instrumentation Group oder dem Standard 1PPS oder dem Standard IEEE 1588 des Institute of Electrical and Electronics Engineers arbeitet, wobei die Zusammenführungseinheit (100) ausgestaltet ist, um logische Knoten gemäß dem Standard IEC 61850-7 der International Electrotechnical Commission zu implementieren, wobei die logischen Knoten TCTR und/oder TVTR umfassen, wobei die Zusammenführungseinheit (100) ausgestaltet ist, um in Abhängigkeit von den Eingabedaten (ID) abgetastete Messwerte SMV zu bestimmen und um Informationen von mindestens einem der logischen Knoten auf das Kommunikationsprotokoll IEC 61850-9-2 für abgetastete Messwerte SMV abzubilden, und wobei:
- die Zusammenführungseinheit (100) eine Steuerungseinheit (120) umfasst, die ausgestaltet ist, um Phasenmessungsinformationen (PHM) in Abhängigkeit von den Eingabedaten (ID) zu bestimmen,
- die Zusammenführungseinheit (100) ausgestaltet ist, um den Phasenmessungsinformationen (PHM) Zeitinformationen zuzuordnen, die von den Zeitsynchronisierungsmitteln (156) geliefert werden,
- die logischen Knoten eine MMXU und/oder eine MMXU, die PMU Phasenmessungsdaten enthält, und/oder ein GGIO umfassen, und
- die Zusammenführungseinheit (100) ausgestaltet ist, um Informationen an und/oder von mindestens einem der logischen Knoten auf das Synchronphasenkommunikationsprotoll IEC 61850-90-5 abzubilden.

2. Zusammenführungseinheit (100) nach Anspruch 1, wobei die Zusammenführungseinheit (100) ausgestaltet ist, um die empfangenen Eingabedaten (ID) in ein vorbestimmtes Ausgabeformat zu transformieren, wodurch transformierte Eingabedaten erhalten werden, und um die transformierten Eingabedaten an eine weitere Vorrichtung (400) auszugeben.

3. Zusammenführungseinheit (100) nach einem der vorstehenden Ansprüche, wobei die Zusammenführungseinheit (100) ausgestaltet ist, um die Phasenmessungsinformationen (PHM) an eine weitere Vorrichtung (400) auszugeben.

4. Zusammenführungseinheit (100) nach einem der vorstehenden Ansprüche, wobei die Zusammenführungseinheit (100) ausgestaltet ist, um Zeitstempelinformationen den Phasenmessungsinformationen (PHM) und/oder den Eingabedaten (ID) und/oder den transformierten Eingabedaten zuzuordnen.

5. Zusammenführungseinheit (100) nach Anspruch 4, wobei die Zusammenführungseinheit (100) ausgestaltet ist, um Informationen an die und/oder von den logischen Knoten auf mindestens eines der folgenden Kommunikationsprotokolle abzubilden: IEC 61850-8-1, Abbildung auf MMS; IEC 61850-8-1 Generic Object Oriented Substation Event, GOOSE.

6. Zusammenführungseinheit (100) nach einem der vorstehenden Ansprüche, wobei die Zusammenführungseinheit (100) ausgestaltet ist, um eine Kommunikation gemäß IEC 61850-8-1 auf einen vorzugsweise dedizierten ersten physikalischen Kommunikationsanschluss (ETH1) abzubilden, und um eine Kommunikation gemäß IEC 61850-9-2 auf einen vorzugsweise dedizierten zweiten physikalischen Kommunikationsanschluss (ETH2) abzubilden.

7. Verfahren zum Betreiben einer Zusammenführungseinheit (100), speziell zur Automatisierung von Unterstationen, wobei die Zusammenführungseinheit (100) mindestens eine Eingabeschnittstelle (110a, 110b) zum Empfangen von Eingabedaten (ID) umfasst, die mindestens eine Spannung und/oder einen Strom mit Bezug auf eine Komponente eines Leistungssystems (200) beschreiben, wobei die Zusammenführungseinheit (100) Zeitsynchronisierungsmittel (156) umfasst, welche eine Schnittstelle zu einem externen Synchronisationsnetzwerk umfassen, das gemäß dem Standard IRIG-B der Inter Range Instrumentation Group oder dem Standard 1PPS oder dem Standard IEEE 1588 des Institute of Electrical and Electronics Engineers arbeitet, wobei die Zusammenführungseinheit (100) logische Knoten gemäß dem Standard IEC 61850-7 der International Electrotechnical Commission implementiert, wobei die logischen Knoten TCTR und/oder TVTR umfassen, wobei die Zusammenführungseinheit (100) abgetastete Messwerte SMV in Abhängigkeit von den Eingabedaten (ID) bestimmt, wobei die Zusammenführungseinheit (100) Informationen an und/oder von mindestens einem der logischen Knoten auf das Kommunikationsprotokoll IEC 61850-9-2 für abgetastete Messwerte SMV abbildet, und wobei:
- die Zusammenführungseinheit (100) unter Verwendung einer Steuerungseinheit (120) Phasenmessungsinformationen (PHM) in Abhängigkeit von den Eingabedaten (ID) bestimmt, wobei die Zusammenführungseinheit (100) den Phasenmessungsinformationen (PHM) Zeitinformationen zuordnet, die von den Zeitsynchronisierungsmitteln (156) geliefert werden,
- die logischen Knoten eine MMXU und/oder eine MMXU, die PMU Phasenmessungsdaten enthält und/oder ein GGIO umfassen, und
- die Zusammenführungseinheit (100) Informationen an und/oder von mindestens einem der logischen Knoten auf das IEC 61850-90-5 Synchronphasenkommunikationsprotokoll abbildet.

8. Verfahren nach Anspruch 7, wobei die Zusammenführungseinheit (100) die empfangenen Eingabedaten (ID) in ein vorbestimmtes Ausgabeformat transformiert, wodurch transformierte Eingabedaten erhalten werden, und die transformierten Eingabedaten an eine weitere Vorrichtung (400) ausgibt.

9. Verfahren nach einem der Ansprüche 7 bis 8, wobei die Zusammenführungseinheit (100) die Phasenmessungsinformationen (PHM) an eine weitere Vorrichtung (400) ausgibt.

10. Verfahren nach einem der Ansprüche 7 bis 9, wobei die Zusammenführungseinheit (100) Zeitstempelinformationen den Phasenmessungsinformationen (PHM) und/oder den Eingabedaten (ID) und/oder den transformierten Eingabedaten zuordnet.

11. Verfahren nach einem der Ansprüche 7 bis 10, wobei die Zusammenführungseinheit (100) Informationen an die und/oder von den logischen Knoten auf mindestens eines der folgenden Kommunikationsprotokolle abbildet: IEC 61850-8-1, Abbildung auf MMS; IEC 61850-8-1 Generic Object Oriented Substation Event, GOOSE; IEEE C37.118.

12. Verfahren nach einem der Ansprüche 7 bis 11, wobei die Zusammenführungseinheit (100) eine Kommunikation gemäß IEC 61850-8-1 auf einen vorzugsweise dedizierten ersten physikalischen Kommunikationsanschluss (ETH1) abbildet und eine Kommunikation gemäß IEC 61850-9-2 auf einen vorzugsweise dedizierten zweiten physikalischen Kommunikationsanschluss (ETH2) abbildet.

## Revendications

1. Unité de fusion (100), en particulier pour l'automatisation de sous-station, comprenant au moins une interface d'entrée (110a, 110b) pour recevoir des données d'entrée (ID) caractérisant au moins une tension et/ou un courant lié à un composant d'un système d'alimentation (200), où ladite unité de fusion (100) comprend des moyens de synchronisation de positionnement temporel (156) qui comprennent une interface vers un réseau de synchronisation externe fonctionnant selon une de la norme de l'Inter Range Instrumentation Group (groupe d'instrumentation inter-gamme), IRIG, -B, de la norme 1PPS et de la norme de l'Institute of Electrical and Electronics Engineers (institut des ingénieurs électriciens et électroniciens), IEEE, 1588, où l'unité de fusion (100) est configurée pour mettre en oeuvre des noeuds logiques selon la norme de l'International Electrotechnical Commission (commission électrotechnique internationale), IEC, 61850-7, où les noeuds logiques comprennent au moins un de TCTR et TVTR, où l'unité de fusion (100) est configurée pour déterminer des valeurs mesurées échantillonnées, SMV, en fonction desdites données d'entrée (ID) et pour mapper des informations d'au moins un des noeuds logiques au protocole de communication de valeurs mesurées échantillonnées, SMV, IEC 61850-9-2, et
où :
- ladite unité de fusion (100) comprend une unité de commande (120) qui est configurée pour déterminer des informations de mesure de phaseur (PHM) en fonction desdites données d'entrée (ID),
- l'unité de fusion (100) est configurée pour associer les informations de mesure de phaseur (PHM) à des informations de positionnement temporel fournies par les moyens de synchronisation de positionnement temporel (156),
- les noeuds logiques comprennent au moins un de MMXU, MMXU comprenant des données de mesure de phaseur PMU et GGIO, et
- l'unité de fusion (100) est configurée pour mapper des informations vers et/ou depuis au moins un des noeuds logiques au protocole de communication Synchrophaseur IEC 61850-90-5.

2. Unité de fusion (100) selon la revendication 1, dans laquelle ladite unité de fusion (100) est configurée pour transformer lesdites données d'entrée reçues (ID) en un format de sortie prédéterminé, moyennant quoi des données d'entrée transformées sont obtenues, et pour sortir lesdites données d'entrée transformées vers un autre dispositif (400).

3. Unité de fusion (100) selon l'une des revendications précédentes, dans laquelle ladite unité de fusion (100) est configurée pour sortir lesdites informations de mesure de phaseur (PHM) vers un autre dispositif (400).

4. Unité de fusion (100) selon l'une des revendications précédentes, dans laquelle ladite unité de fusion (100) est configurée pour assigner des informations d'estampille temporelle auxdites informations de mesure de phaseur (PHM) et/ou auxdites données d'entrée (ID) et/ou auxdites données d'entrée transformées.

5. Unité de fusion (100) selon la revendication 4, dans laquelle ladite unité de fusion (100) est configurée pour mapper des informations vers et/ou depuis lesdits noeud logiques à au moins un des protocoles de communication suivants : IEC 61850-8-1, Mappage vers MMS ; IEC 61850-8-1 Generic Object Oriented Substation Event (événement de sous-station orienté objet générique), GOOSE.

6. Unité de fusion (100) selon l'une des revendications précédentes, dans laquelle ladite unité de fusion (100) est configurée pour mapper des communications selon IEC 61850-8-1 vers un premier port de communications physique, de préférence dédié (ETH1), et pour mapper des communications selon IEC 61850-9-2 vers un second port de communications physique, de préférence dédié (ETH2).

7. Procédé d'exploitation d'une unité de fusion (100), en particulier pour l'automatisation de sous-station, dans lequel ladite unité de fusion (100) comprend au moins une interface d'entrée (110a, 110b) pour recevoir des données d'entrée (ID) caractérisant au moins une tension et/ou un courant lié à un composant d'un système d'alimentation (200), où ladite unité de fusion (100) comprend des moyens de synchronisation de positionnement temporel (156) qui comprennent une interface vers un réseau de synchronisation externe fonctionnant selon une de la norme de l'Inter Range Instrumentation Group (groupe d'instrumentation inter-gamme), IRIG, -B, de la norme 1PPS et de la norme de l'Institute of Electrical and Electronics Engineers (institut des ingénieurs électriciens et électroniciens), IEEE, 1588, où l'unité de fusion (100) met en oeuvre des noeuds logiques selon la norme de l'International Electrotechnical Commission (commission électrotechnique internationale), IEC, 61850-7, où les noeuds logiques comprennent au moins un de TCTR et TVTR, où l'unité de fusion (100) détermine des valeurs mesurées échantillonnées, SMV, en fonction des données d'entrée (ID), où l'unité de fusion (100) mappe des informations vers et/ou depuis au moins un des noeuds logiques au protocole de communication de valeurs mesurées échantillonnées, SMV, IEC 61850-9-2, et où :
- ladite unité de fusion (100) détermine, en utilisant une unité de commande (120), des informations de mesure de phaseur (PHM) en fonction desdites données d'entrée (ID), l'unité de fusion (100) associe les informations de mesure de phaseur (PHM) à des informations de positionnement temporel fournies par les moyens de synchronisation de positionnement temporel (156),
- les noeuds logiques comprennent au moins un de MMXU, MMXU comprenant des données de mesure de phaseur PMU et GGIO, et
- l'unité de fusion (100) mappe des informations vers et/ou depuis au moins un des noeuds logiques au protocole de communication Synchrophaseur IEC 61850-90-5.

8. Procédé selon la revendication 7, dans lequel ladite unité de fusion (100) transforme lesdites données d'entrée reçues (ID) en un format de sortie prédéterminé, moyennant quoi des données d'entrée transformées sont obtenues, et sort lesdites données d'entrée transformées vers un autre dispositif (400).

9. Procédé selon l'une des revendications 7 à 8, dans lequel ladite unité de fusion (100) sort lesdites informations de mesure de phaseur (PHM) vers un autre dispositif (400).

10. Procédé selon l'une des revendications 7 à 9, dans lequel ladite unité de fusion (100) assigne des informations d'estampille temporelle auxdites informations de mesure de phaseur (PHM) et/ou auxdites données d'entrée (ID) et/ou auxdites données d'entrée transformées.

11. Procédé selon l'une des revendications 7 à 10, dans lequel ladite unité de fusion (100) mappe des informations vers et/ou depuis lesdits noeuds logiques à au moins un des protocoles de communication suivantes : IEC 61850-8-1, Mappage vers MMS ; IEC 61850-8-1 Generic Object Oriented Substation Event (événement de sous-station orienté objet générique) GOOSE ; IEEE C37.118.

12. Procédé selon l'une des revendications 7 à 11, dans lequel ladite unité de fusion (100) mappe des communications selon IEC 61850-8-1 vers un premier port de communications physique, de préférence dédié (ETH1), et mappe des communications selon IEC 61850-9-2 vers un second port de communications physique, de préférence dédié (ETH2).
